# EUROPEAN PATENT APPLICATION

(11) **EP 4 459 832 A1**
(43) Date of publication of application: **06.11.2024**
(21) Application number: 24172025.9
(22) Date of filing: 23.04.2024
(51) Int. Cl.: H02J 7/00, H01M 10/052

(54) **CHARGING CONTROL METHOD, AND CHARGING CONTROL APPARATUS AND BATTERY PACK PERFORMING THE SAME**

(30) Priority: 02.05.2023 KR 20230057217
(71) Applicant: Samsung SDI Co., Ltd., Yongin-si, Gyeonggi-do 17084 (KR)
(72) Inventor: KIM, Hwa-Su, 17084 Yongin-si (KR); CHUN, Chang Yoon, 17084 Yongin-si (KR); CHO, Wonkyoung, 17084 Yongin-si (KR); YOON, Sungjin, 17084 Yongin-si (KR)
(74) Representative: Marks & Clerk LLP

(57) **Abstract**

A charging control apparatus may include a storage device configured to store a battery model, a detection device configured to detect an external state value including at least one of a voltage, a current, or a temperature of a battery, and a control device configured to control a charging current by using feedback loop control in which at least one internal state value of the battery is estimated by using the battery model and the external state value, and configured to determine a first charging current value based on the at least one internal state value.

## Description

### BACKGROUND

### 1. Field

The present disclosure relates to a charging control method, and a charging control apparatus and a battery pack performing the same.

### 2. Description of the Related Art

A secondary battery differs from a primary battery in that charging and discharging can be repeated, whereas the primary battery only provides nonreversible conversion from chemical energy to electrical energy. A low-capacity secondary battery is used as a power supply device for small electronic devices, such as portable telephones, laptops computers, and camcorders, and a highcapacity secondary battery is used as a power supply device for hybrid vehicles and the like.

In general, a secondary battery cell may include an electrode assembly including a positive electrode, a negative electrode, a separator interposed between the positive electrode and the negative electrode, a case for accommodating the electrode assembly therein, and an electrode terminal electrically connected to the electrode assembly. An electrolyte solution is injected into the case to enable charging and discharging of the battery cell through an electrochemical reaction of the positive electrode, the negative electrode, and the electrolyte solution. A shape of the case, such as cylindrical or rectangular, may depend on an application of the battery cell.

Battery cells may be connected in series and/or parallel to form a battery module having high energy density. A battery pack may include one or more of these battery modules according to required specifications.

As a charging method of a secondary battery cell, a constant current (CC) method, a constant voltage (CV) method, a constant power (CP) method, and a constant current and constant voltage (CCCV) method are mainly used. These methods are charging control methods based on external conditions of the secondary battery, such as current, voltage, and power, and may have limitations in improving deterioration due to charging of the secondary battery.

The deterioration caused by charging may be one of the main factors that reduce the lifespan of a secondary battery. Therefore, to increase the lifespan of the secondary battery, it may be desirable to suppress deterioration due to charging. As a method of reducing deterioration due to charging, there is a method of charging the secondary battery with a low rate current while maintaining the temperature of the secondary battery at an appropriate temperature. However, as demand for high-speed charging has recently increased, a charging technology capable of reducing or minimizing charging deterioration of a battery while charging at a high rate of current may be desirable.

### SUMMARY

The present disclosure attempts to provide a charging control method, and a charging control apparatus and a battery pack performing the same while being capable of high rate charging and capable of improving degradation due to charging.

A charging control apparatus may include a storage device configured to store a battery model, a detection device configured to detect an external state value including at least one of a voltage, a current, and a temperature of a battery, and a control device configured to control a charging current by using feedback loop control in which at least one internal state value of the battery is estimated by using the battery model and the external state value, and configured to determine a first charging current value based on the estimated at least one internal state value.

The control device may be configured to determine the first charging current value such that the at least one internal state value converges to a target value, and may be configured to control the charging current based on the first charging current value.

The target value may correspond to a boundary value between a high degradation region and a low degradation region divided with reference to an internal state of the battery.

The internal state may include an anode potential, wherein the target value includes a value that is greater than 0.

The internal state may include a cathode potential, wherein the target value includes a value that is less than an operating region voltage of a battery cell of the battery.

The battery model may include an electrochemical model for modelling an internal state of a secondary battery cell having one or more specifications that are substantially similar to those of the battery.

The control device may be configured to estimate a plurality of internal state values corresponding to a plurality of internal state parameters of the battery by using the battery model and the external state value, may be configured to determine, for each of the plurality of internal state parameters, a current range so that the corresponding internal state value converges to the corresponding target value, and may be configured to determine a current value satisfying all of the current ranges corresponding to the plurality of internal state parameters as the first charging current value.

The control device may be configured to estimate a plurality of internal state values corresponding to a plurality of internal state parameters of the battery by using the battery model and the external state value, may be configured to determine, for each of the plurality of internal state parameters, a second charging current value so that the corresponding internal state value converges to the corresponding target value, and may be configured to determine the first charging current value by sequentially referring to the second charging current values corresponding to the plurality of internal state parameters according to a processing sequence determined based on priorities assigned to the plurality of the internal state parameters.

The control device may include one or more controllers capable of the feedback loop control, wherein the controller is configured to perform at least one control function of proportional (P) control, integral (I) control, and differential (D) control.

The control device may be configured to communicate with a charger, and may be configured to control a charging current by transferring the first charging current value to the charger.

A battery pack may include a battery and the charging control apparatus.

The control device may include a battery management system of the battery pack.

A charging control method of a battery pack may include detecting an external state value including at least one of a voltage, a current, and a temperature of a battery, estimating at least one internal state value indicating an internal state of the battery by using a battery model and the external state value, determining a first charging current value based on the estimated at least one internal state value, controlling a charging current of a charger based on the first charging current value, and repeatedly performing the detecting, the estimating, the determining, and the controlling, while charging the battery pack.

The first charging current value may be determined such that the at least one internal state value converges to a target value.

The target value may correspond to a boundary value between a high degradation region and a low degradation region divided with reference to the internal state of the battery.

The internal state may include at least one of an anode potential, a cathode potential, and a cathode concentration.

The battery model may include an electrochemical model for modelling an internal state of a secondary battery cell having one or more specifications that are substantially similar to those of the battery.

The estimating may include estimating a plurality of internal state values corresponding to a plurality of internal state parameters of the battery by using the battery model and the external state value.

The determining the first charging current value may include determining, for each of the plurality of internal state parameters, a current range so that the corresponding internal state value converges to the corresponding target value, and determining a current value satisfying all of the current ranges corresponding to the plurality of internal state parameters as the first charging current value.

The determining the first charging current may include determining, for each of the plurality of internal state parameters, a second charging current value so that the corresponding internal state value converges to the corresponding target value, and determining the first charging current value by sequentially referring to the second charging current values corresponding to the plurality of internal state parameters according to a processing sequence determined based on priorities assigned to the plurality of the internal state parameters.

According to one or more embodiments, the charging speed may be increased while reducing or maximally suppressing the degradation of the battery pack.

At least some of the above and other features of the invention are set out in the claims.

### BRIEF DESCRIPTION OF THE DRAWINGS

FIG. 1 schematically illustrates a charging system of a battery pack according to one or more embodiments.
FIG. 2 schematically illustrates a charging control method of a battery pack according to one or more embodiments.
FIG. 3 schematically illustrates a charging system of a battery pack according to one or more other embodiments.
FIG. 4 schematically illustrates a charging control method of a battery pack according to one or more other embodiments.
FIG. 5 is a drawing for describing an aspect of a charging control method according to one or more embodiments.

### DETAILED DESCRIPTION

Aspects of some embodiments of the present disclosure and methods of accomplishing the same may be understood more readily by reference to the detailed description of embodiments and the accompanying drawings. The described embodiments are provided purely as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure. The present disclosure covers all modifications, equivalents, and replacements within the idea and technical scope of the present disclosure. Further, each of the features of the various embodiments of the present disclosure may be combined with each other, in part or in whole, and technically various interlocking and driving are possible. Each embodiment may be implemented independently of each other or may be implemented together in an association.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or nonintegral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expression such as "at least one of A and B" and "at least one of A or B" may include A, B, or A and B. As used herein, "or" generally means "and/or," and the term "and/or" includes any and all combinations of one or more of the associated listed items. For example, the expression such as "A and/or B" may include A, B, or A and B. Similarly, expressions such as "at least one of," "a plurality of," "one of," and other prepositional phrases, when preceding a list of elements, modify the entire list of elements and do not modify the individual elements of the list.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the term "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

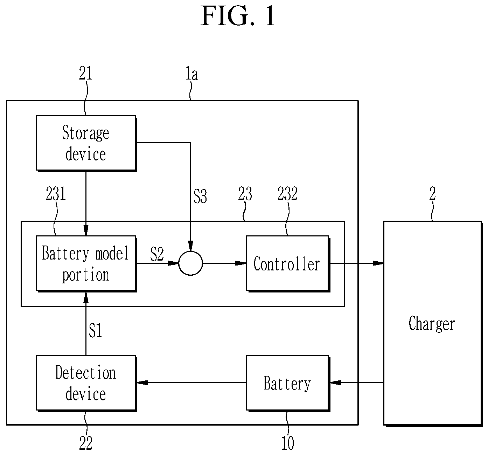

FIG. 1 schematically illustrates a charging system of a battery pack according to one or more embodiments.

Referring to FIG. 1, a charging system of a battery pack 1a according to one or more embodiments includes a charging control apparatus included in the battery pack 1a, and includes a charger 2 external to the battery pack 1a.

The battery pack 1a includes a battery 10 and the charging control apparatus.

The battery 10 may include at least one secondary battery cell.

The charging control apparatus may include a storage device 21, a detection device 22, and a control device 23.

The storage device 21 may store programs for operation of the charging control apparatus, and may store various data processed by the charging control apparatus.

The storage device 21 may store an electrochemical model (hereinafter, referred to as a "battery model") for modeling an internal state of the secondary battery cell having the same specifications as the battery cell of the battery 10. For example, the storage device 21 subdivides the external state (for example, current, cell voltage, temperature, and/or the like) of the secondary battery cell. The storage device 21 may store the battery model in the form of a table for mapping the internal state (for example, cathode potential, anode potential, cathode concentration, and/or the like) of the secondary battery cell as calculated for each state by using the battery model. In addition, for example, the storage device 21 may store the battery model of the secondary battery cell in the form of a function that receives a state value representing the external state of the secondary battery cell (for example, current, voltage, temperature, and/or the like). Also, the storage device 21 may output a state value representing the internal state (for example, cathode potential, anode potential, cathode concentration, and/or the like) of the secondary battery cell.

The storage device 21 may store an internal state target value that serves as a reference for controlling the internal state of the battery 10 as not to progress to a region in which the charging degradation is high. A region (hereinafter, referred to as a "low degradation region") having a relatively low level of charging degradation, and another region (hereinafter, referred to as a "high degradation region") having a relatively high level of charging degradation, with reference to the internal state of the battery 10, may be confirmed in advance based on simulation, experiment, or the like of the secondary battery cell having the same or similar specifications as the secondary battery cell of the battery 10. The internal state target value stored in the storage device 21 may be defined as an internal state value immediately before the internal state of the battery 10 progresses to the high degradation region based on the low degradation region and the high degradation region that have been previously identified. In one or more embodiments, the internal state value may be a boundary value for distinguishing the low degradation region from the high degradation region.

For example, if the internal state parameter of the battery 10 is anode potential, the internal state target value may be set to be a value greater than about 0. In addition, for example, if the internal state parameter of the battery 10 is cathode potential, the internal state target value may be set to be a value that is less than operating region voltage of battery cell. In addition, for example, if the internal state parameter of the battery 10 is the cathode concentration, the internal state target value may be set to be lower than about 30% of an upper or maximum concentration value.

The low degradation region and the high degradation region of the battery 10 may be varied according to the degree of degradation of the battery 10. In one or more embodiments, the storage device 21 may subdivide the degree of degradation of the battery 10 based on a lifespan model of the battery 10. Also, the storage device 21 may map and store the internal state target value that serves as the reference for controlling the internal state of the battery 10 as not to progress to the high degradation region, with respect to respective degrees of degradation.

The detection device 22 may monitor the state of the battery cell of the battery 10 to continuously detect an external state of the battery 10, such as voltage (e.g., cell voltage), current, temperature, and/or the like. The detection device 22 may transfer a state value/external state value S1 of the detected external state to the control device 23 if the external state of the battery 10 is detected.

The control device 23 may estimate the internal state of the battery 10 based on the external state value S1 received from the detection device 22 and based on the battery model (e.g., pre-stored battery model). The control device 23 may control a charging current of the charger 2 in real time by a feedback loop method such that the estimated internal state value of the battery 10 converges to the internal state target value S3 (e.g., pre-stored internal state target value).

The control device 23 may include a battery model portion 231 and a controller 232.

If the external state value S1 of the battery 10 is received from the detection device 22, the battery model portion 231 may estimate the internal state of the battery 10 corresponding to the received external state value S1 by using the battery model (e.g., pre-stored battery model). The battery model is generated by modeling electrochemical characteristics of one secondary battery cell. In one or more embodiments, if the battery 10 includes a plurality of battery cells, the battery model portion 231 may estimate an internal state representing internal states of the battery cells of the battery 10 by using an average external state value (average cell voltage, average current, average temperature, and/or the like) of the plurality of battery cells, or the external state value (cell voltage, current, temperature, and/or the like) of a representative cell of the battery cells. For example, the battery model portion 231 may select a weak cell having a greatest degree of degradation among the battery cells as the representative cell, and may estimate the internal state of the battery 10 by inputting the external state value detected with respect to the selected weak cell.

The battery model portion 231 may select one of internal state parameters that may be estimated by using the battery model as a control parameter for controlling the charging current, and may output the internal state value S2 of the selected the control parameter to the controller 232. The battery model portion 231 may select a parameter that may identify the degree of charging degradation of the battery cell, such as the cathode potential, the anode potential, the cathode concentration, and/or the like among the internal state parameters of the battery 10 that may be estimated by using the battery model, as the control parameter.

The controller 232 may continuously receive the internal state value S2 corresponding to the control parameter from the battery model portion 231, and based on this, may control the charging current in real time by a feedback loop method such that the internal state value of the battery 10 converges to the internal state target value S3 (e.g., the predetermined internal state target value). In one or more embodiments, if the internal state value S2 corresponding to the control parameter is received from the battery model portion 231, the controller 232 repeatedly performs control of the charging current in real time such that the received internal state value S2 converges to the corresponding internal state target value S3. In one or more embodiments, the controller 232 may maintain the internal state of the battery 10 at the state immediately preceding entry into the high degradation region.

The controller 232 may communicate with the charger 2 through controller area network (CAN) communication or the like. If the value of the charging current is determined such that the internal state value S2 of the control parameter converges to the corresponding internal state target value S3, the controller 232 may control the charging current that is applied to the battery 10 from the charger 2 in real time by transferring the determined current value to the charger 2 in real time.

The control device 23 may be implemented by a battery management system (BMS) of the battery pack 1a. In addition, the controller 232 may be implemented by one or more controller that is capable of feedback loop control, and that is configured to perform at least one control function of proportional (P) control, integral (I) control, and/or differential (D) control.

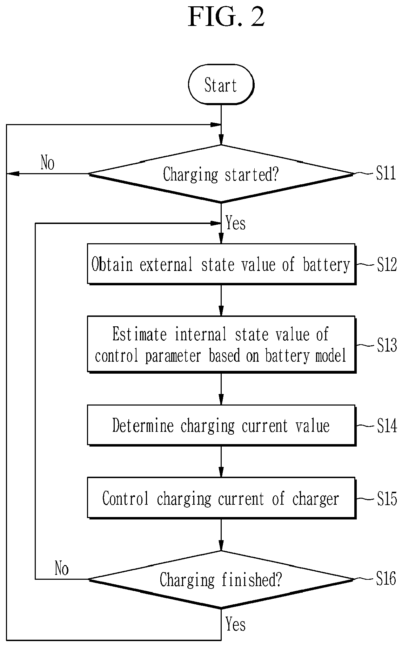

FIG. 2 schematically illustrates a charging control method of a battery pack according to one or more embodiments. The charging control method of FIG. 2 may be performed by the charging control device 23 described with reference to FIG. 1.

Referring to FIG. 2, if the charging of the battery 10 begins at operation S11, then, at operation S12, the control device 23 may obtain the external state value of the battery cell of the battery 10 (e.g., current, cell voltage, temperature, and/or the like) through the detection device 22.

If the external state value is obtained, at operation S13, the control device 23 estimates the internal state value corresponding to the control parameter of the battery 10 (e.g., the anode potential, the cathode potential, the cathode concentration, and/or the like) based on the battery model.

In addition, the control device 23 determines, at operation S14, the charging current value of the charger 2. This may be such that the estimated internal state value of the control parameter converges to the corresponding internal state target value. At operation S15, the control device 23 controls the charging current of the charger 2 in real time.

By repeatedly performing the above described operations S12 to S15 until the charging of the battery 10 is finished at operation S16, the control device 23 may maintain the internal state of the battery cell at the state immediately preceding the high degradation region.

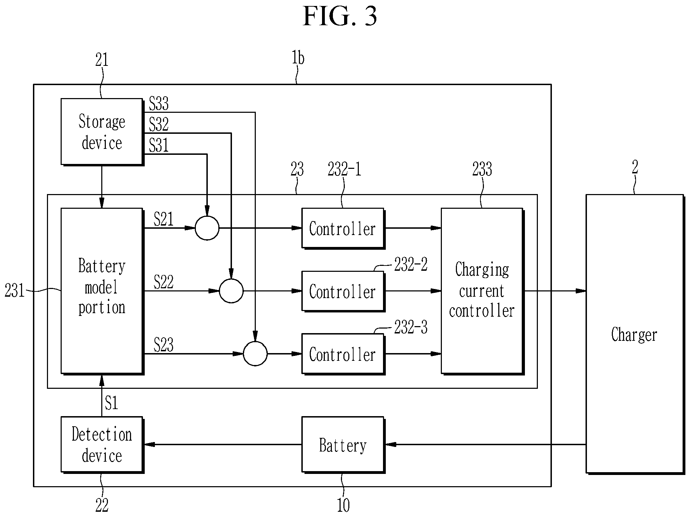

FIG. 3 schematically illustrates a charging system of a battery pack according to one or more other embodiments. Hereinafter, in descriptions of components constituting a charging system according to one or more other embodiments, duplicate descriptions of the same components as those constituting the charging system of FIG. 1 may be omitted.

Referring to FIG. 3, a charging system of a battery pack 1b according to one or more embodiments includes the charging control apparatus included in a battery pack 1b, and includes the charger 2 external to the battery pack 1b.

The battery pack 1b includes the battery 10 and the charging control apparatus.

The battery 10 may include at least one secondary battery cell.

The charging control apparatus include the storage device 21, the detection device 22, and the control device 23.

The storage device 21 may store the battery model in the form of a table or function. The battery model is an electrochemical model for modelling an internal state of the secondary battery cell having the same specification as the battery cell of the battery 10.

The storage device 21 may store the internal state target value that serves as the reference for controlling the internal state of the battery 10 during charging as not to progress to the region in which the charging degradation is high. The storage device 21 may map and may store the corresponding internal state target values with respect to a plurality of the control parameters selected from among the internal state parameters that may be estimated by using the battery model. The storage device 21 may subdivide the degree of degradation of the battery 10 based on a lifespan model of the battery 10, and may map and store the internal state target values of the plurality of the control parameters with respect to respective degrees of degradation.

The detection device 22 may continuously detect the external state of the battery 10 (e.g., voltage/cell voltage, current, temperature, and/or the like), and may transfer the detected external state value S1 to the control device 23.

The control device 23 estimates the internal state of the battery 10 based on the external state value S1 received from the detection device 22 and based on the battery model (e.g., pre-stored battery model), and controls the charging current of the charger 2 in real time by a feedback loop method such that the estimated internal state value of the battery 10 converges to the internal state value S3 (e.g., pre-stored internal state target value).

The control device 23 may include the battery model portion 231, and a plurality of controllers 232-1, 232-2, and 232-3, and the charging current controller 233.

If the external state value S1 of the battery 10 is received from the detection device 22, the battery model portion 231 estimates the internal state of the battery 10 corresponding to the received the external state value S1 by using the battery model (e.g., pre-stored battery model). If the battery 10 includes the plurality of battery cells, the battery model portion 231 may estimate the internal state of the battery 10 by using the average of the external state value (e.g., average cell voltage, average current, average temperature, and/or the like) of the plurality of battery cells, or by using the external state value (e.g., cell voltage, current, temperature, and/or the like) of a representative cell selected from the plurality of battery cells.

The battery model portion 231 may select the plurality of the control parameters among the internal state parameters that may be estimated by using the battery model as the control parameter for controlling the charging current, and may output the internal state values S21, S22, and S23 of the selected the control parameters to the plurality of controllers 232-1, 232-2, and 232-3, respectively. For example, the battery model portion 231 may select the cathode potential, the anode potential, and the cathode concentration among the internal state parameters of the battery 10, which may be estimated by using the battery model as the control parameter.

Each of the controllers 232-1, 232-2, and 232-3 may continuously receive the internal state values S21, S22, and S23 corresponding to the respective control parameters from the battery model portion 231, and based thereon, determines the charging current value for converging the internal state value of the battery 10 to the internal state target values S31, S32, and S33 (e.g., predetermined internal state target values). Each of the controllers 232-1, 232-2, and 232-3 may transfer such determined information of the charging current value to the charging current controller 233. The charging current value transferred from each of the controllers 232-1, 232-2, and 232-3 to the charging current controller 233 may include a single value, or may include information with respect to a current range (e.g., predetermined current range) defined by an upper limit value and by a lower limit value.

If the information with respect to the charging current value is received from each of the controllers 232-1, 232-2, and 232-3, the charging current controller 233 controls, in real time, the charging current of the charger 2 based on the information.

The charging current controller 233 may determine the charging current value concurrently or substantially simultaneously satisfying the charging current value received from each of the controllers 232-1, 232-2, and 232-3, and may control the charging current of the charger 2 by using the charging current value. In one or more embodiments, the charging current controller 233 may detect an overlapping portion between current regions indicated by the respective charging current values received from the controllers 232-1, 232-2, and 232-3, and may determine the charging current value for controlling the charger 2 in the detected overlapping portion.

The charging current controller 233 may assign different priorities with respect to the plurality of the control parameters. For example, the charging current controller 233 may assign a higher priority to the control parameter as the sensitivity of the control parameter with respect to a change in the charging current increases. The charging current controller 233 may determine a processing sequence of the charging current values respectively received from the controllers 232-1, 232-2, and 232-3 based on the priority, and may control the charging current of the charger 2 in a serial control method in which the charging current values are sequentially referenced according to the determined processing sequence.

The charging current controller 233 may communicate with the charger 2 through CAN communication or the like. The charging current controller 233 may control the charging current applied to the battery 10 from the charger 2 in real time by transferring the finally determined charging current value to the charger 2 in real time.

The aforementioned control device 23 may be implemented by a battery management system (BMS) of the battery pack 1b. In addition, the plurality of controllers 232-1, 232-2, and 232-3 may be implemented by one or more controllers that are capable of feedback loop control, and that are configured to perform at least one control function of proportional (P) control, integral (I) control, and/or differential (D) control.

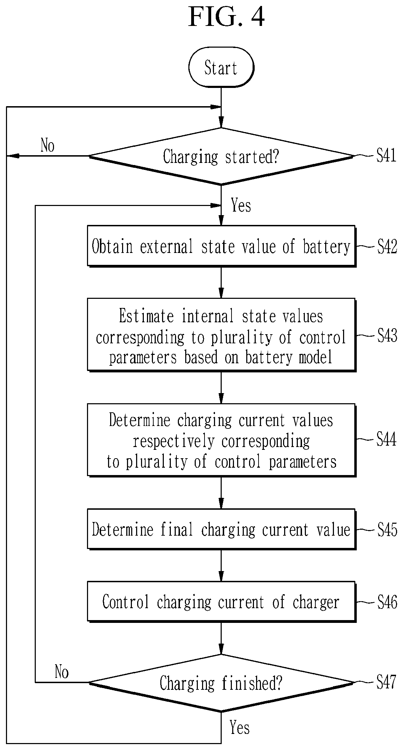

FIG. 4 schematically illustrates a charging control method of a battery pack according to one or more other embodiments. The charging control method of FIG. 4 may be performed by the charging control device 23 described with reference to FIG. 3.

Referring to FIG. 4, if the charging of the battery 10 is started at operation S41, then, at operation S42, the control device 23 obtains the external state value of the battery cell of the battery 10 (e.g., current, cell voltage, temperature, and/or the like) through the detection device 22.

If the external state value is obtained, at operation S43, the control device 23 estimates the internal state value corresponding to each of the plurality of the control parameters of the battery 10 (for example, the anode potential, the cathode potential, and the cathode concentration) based on the battery model.

In addition, at operation S44, the control device 23 determines the charging current values with respect to the plurality of the control parameters, such that the estimated internal state value converges to the corresponding internal state target value with respect to each of the plurality of the control parameters.

If the charging current value corresponding to each of the plurality of the control parameters is determined, at operation S45, the control device 23 determines the final charging current value to be used in controlling the charging current of the charger 2 based on the charging current values.

At the operation S45, the control device 23 may determine, as the final charging current value, the charging current value that concurrently or substantially simultaneously satisfies all of the plurality of the control parameters. In one or more embodiments, the control device 23 may detect an overlapping portion between current regions indicated by the charging current values corresponding to the respective control parameters, and may determine the final charging current value for controlling the charger 2 in the detected overlapping portion.

At the operation S45, based on priorities assigned to the plurality of the control parameters, the control device 23 may sequentially select the charging current values corresponding to the respective control parameters as the final charging current value for controlling the charger 2.

If the final charging current value is determined, at operation S46, the control device 23 may control the charging current of the charger 2 in real time by using this final charging current value.

By repeatedly performing the above described S42 to S46 until the charging of the battery 10 is finished at operation S47, the control device 23 may maintain the internal state of the battery cell to the state immediately preceding entering into the high degradation region.

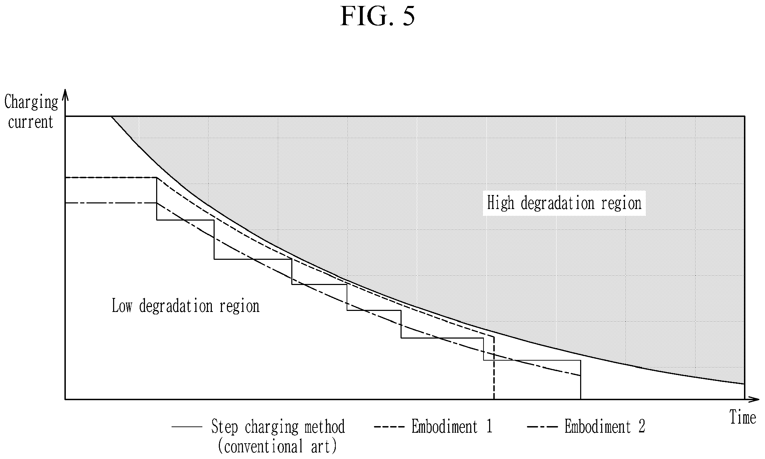

FIG. 5 is a drawing for describing an aspect of a charging control method according to one or more embodiments.

Referring to FIG. 5, the conventional step charging method performed in a feedforward method may have a disadvantage in that it may be difficult to finely control the charging current. In contrast, in the above-described embodiments, it is possible to control the charging current in real time according to the change in the internal state of the battery 10 in a feedback loop manner.

In addition, by controlling the charging current in a state immediately prior to proceeding to the high degradation region, as in one or more embodiments, there is an aspect of shortening, or reducing, the charging time. In addition, if the charging current is controlled in the region that is lower than the charging current value calculated by the feedback loop method by a margin (e.g., predetermined margin), as in one or more other embodiments, the peak charging current may be lowered even if the same charging time elapses as in the step charging method, and thus, in the long term, the longer lifespan may be secured in comparison with the step charging method.

An electronic or electrical device and/or any other related device or component according to the embodiments of the present disclosure that are described herein may be implemented by using any suitable hardware, firmware (e.g., an application-specific integrated circuit), software, or a combination of software, firmware, and hardware. For example, various components of these devices may be disposed on one integrated circuit (IC) chip or on separate IC chips. In addition, various components of these devices may be implemented on a flexible printed circuit film (TCP), a tape carrier package (TCP), a printed circuit board (PCB), or on one substrate. The electrical connections or interconnections described in the present specification may be implemented by wires or conductive elements, e.g., on a PCB or on other types of circuit carriers. The conductive element may include, e.g., metallization, such as surface metallization, and/or pins, and may include conductive polymers or ceramics. Electrical energy may also be transmitted via a wireless connection using, e.g., electromagnetic radiation or light.

In addition, various components of these devices may be executed on one or more processors to perform various functions described herein and within one or more computing devices, and may be processes or threads that execute computer program instructions and may interact with other system components. Computer program instructions are stored in a memory that can be implemented in a computing device using a standard memory device, such as, e.g., a random access memory (RAM). The computer program instructions may also be stored on other non-transitory computer readable media, e.g., CD-ROMs, flash drives, and/or the like.

In addition, those skilled in the art should recognize that the functions of various computing devices may be combined or integrated into a single computing device, or a function of a corresponding computing device may be distributed across one or more other computing devices without departing from the scope of the present disclosure.

While embodiments been described in connection with what is presently considered to be practical embodiments, it is to be understood that the present disclosure is not limited to the disclosed embodiments, but, on the contrary, is intended to cover various modifications and equivalent arrangements included within the scope of the appended claims, with functional equivalents thereof to be included therein.

### Description of Some of the Reference Characters

| | | | | | |
|---|---|---|---|---|---|
| 1: | battery pack | 2: | charger | 10: | battery |
| 21: | storage device | 22: | detection device | 23: | control device |
| 231: | the battery model portion | | | 232, 232-1, 232-2, 232-3: | controller |
| 233: | the charging current controller | | | | |

Embodiments are set out in the following clauses:
Clause 1. A charging control apparatus, comprising:
   a storage device configured to store a battery model;
   a detection device configured to continuously detect an external state value comprising
   at least one of a voltage, a current, and a temperature of the battery; and
   a control device configured to control a charging current in real time by using a feedback loop method in which at least one state value indicating an internal state of the battery is estimated by using the battery model and the external state value, and configured to determine a first charging current value based on the estimate of the at least one internal state value.
Clause 2. The charging control apparatus as defined in clause 1, wherein the control device is configured to determine the first charging current value such that the at least one internal state value converges to a predetermined target value, and is configured to control the charging current based on the determined first charging current value.
Clause 3. The charging control apparatus as defined in clause 2, wherein the target value corresponds to a boundary value between a high degradation region and a low degradation region divided with reference to the internal state of the battery.
Clause 4. The charging control apparatus as defined in clause 3, wherein, if the internal state is an anode potential, the target value is set to be a value greater than 0.
Clause 5. The charging control apparatus as defined in clause 3, wherein, if the internal state is a cathode potential, the target value is set to be a value smaller than an operating region voltage of a battery cell constituting the battery.
Clause 6. The charging control apparatus as defined in any one of clauses 2 to 5, wherein:
   the control device is configured to determine second charging current values for a plurality of internal state values that are estimated by using the battery model to converge to the target values, respectively, and is configured to determine a current value satisfying all of the second charging current values as the first charging current value; and.
   the second charging current values are set in a predetermined current range.
Clause 7. The charging control apparatus as defined in any one of clauses 2 to 6, wherein the control device is configured to determine second charging current values for a plurality of internal state values that are estimated by using the battery model to converge the target value, respectively, and is configured to determine the first charging current value by sequentially referring to the second charging current values corresponding to the plurality of the internal state values according to a processing sequence determined based on a predetermined priority.
Clause 8. The charging control apparatus as defined in any one of clauses 1 to 7, wherein the battery model is an electrochemical model for modelling an internal state of a secondary battery cell having a same specification as the battery.
Clause 9. The charging control apparatus as defined in any one of clauses 1 to 8, wherein:
   the control device comprises one or more controller capable of the feedback loop control; and
   the controller is configured to perform at least one control function of proportional (P) control, integral (I) control, and/or differential (D) control.
Clause 10. The charging control apparatus as defined in clause 1, wherein the control device is configured to communicate with a charger, and is configured to control a charging current in real time by transferring the first charging current value to the charger.
Clause 11. A battery pack, comprising:
   a battery; and
   the charging control apparatus according to any one of clause 1 to clause 10.
Clause 12. The battery pack as claimed in defined in clause 11, wherein the control device is a battery management system of the battery pack.
Clause 13. A charging control method of a battery pack, the charging control method comprising:
   detecting an external state value comprising at least one of a voltage, a current, and a temperature of the battery;
   estimating at least one state value indicating an internal state of the battery by using a battery model and the external state value;
   determining a first charging current value based on the estimated at least one internal state value;
   controlling a charging current of a charger in real time based on the first charging current value; and
   repeatedly performing the detecting, the estimating, the determining, and the controlling, while charging of the battery pack is performed.
Clause 14. The charging control method as defined in clause 13, wherein
   determining the first charging current value comprises:
   determining the first charging current value such that the at least one internal state value converges to a predetermined target value.
Clause 15. The charging control method as defined in clause 14, wherein the target value corresponds to a boundary value between a high degradation region and a low degradation region divided with reference to the internal state of the battery.
Clause 16. The charging control method as defined in any one of clauses 13 to 15, wherein the internal state comprises at least one of an anode potential, a cathode potential, and/or a cathode concentration.
Clause 17. The charging control method as defined in any one of clauses 13 to 16, wherein the battery model is an electrochemical model for modelling an internal state of a secondary battery cell having a same specification as the battery.
Clause 18. The charging control method as defined in any one of clauses 13 to 17, wherein determining the first charging current value such that the at least one internal state value converges to the target value comprises:
   determining second charging current values for a plurality of internal state values estimated by using the battery model to converge to the target value; and
   determining a current value satisfying all of the second charging current values determined with respect to the plurality of internal state values, as the first charging current value.
   wherein the second charging current values are set in a predetermined current range.
Clause 19. The charging control method as defined in in any one of clauses 13 to 17, wherein determining the first charging current value such that the at least one internal state value converges to the target value comprises:
   determining second charging current values for a plurality of internal state values estimated by using the battery model to converge to the target value; and
   determining the first charging current value by sequentially referring to the second charging current values corresponding to the plurality of the internal state values according to a processing sequence determined based on a predetermined priority.

## Claims

1. A charging control apparatus comprising:
a storage device configured to store a battery model;
a detection device configured to detect an external state value comprising at least one of a voltage, a current, and a temperature of a battery; and
a control device configured to control a charging current by using feedback loop control in which at least one internal state value of the battery is estimated by using the battery model and the external state value, and configured to determine a first charging current value based on the at least one internal state value.

2. The charging control apparatus as claimed in claim 1, wherein the control device is configured to determine the first charging current value such that the at least one internal state value converges to a target value, and is configured to control the charging current based on the first charging current value, optionally wherein the target value corresponds to a boundary value between a high degradation region and a low degradation region divided with reference to an internal state of the battery.

3. The charging control apparatus as claimed in claim 2, wherein the internal state comprises an anode potential, and wherein the target value comprises a value that is greater than 0, or the internal state comprises a cathode potential, and wherein the target value comprises a value that is less than an operating region voltage of a battery cell of the battery.

4. The charging control apparatus as claimed in claim 1, wherein the control device is configured to:
estimate a plurality of internal state values corresponding to a plurality of internal state parameters of the battery by using the battery model and the external state value;
determine, for each of the plurality of internal state parameters, a current range so that the corresponding internal state value converges to the corresponding target value; and
determine a current value satisfying all of the current ranges corresponding to the plurality of internal state parameters as the first charging current value.

5. The charging control apparatus as claimed in claim 1, wherein the control device is configured to:
estimate a plurality of internal state values corresponding to a plurality of internal state parameters of the battery by using the battery model and the external state value;
determine, for each of the plurality of internal state parameters, a second charging current value so that the corresponding internal state value converges to the corresponding target value; and
determine the first charging current value by sequentially referring to the second charging current values corresponding to the plurality of internal state parameters according to a processing sequence determined based on priorities assigned to the plurality of the internal state parameters.

6. The charging control apparatus as claimed in any one of the preceding claims, wherein the control device comprises one or more controllers capable of the feedback loop control; and
wherein the controller is configured to perform at least one control function of proportional (P) control, integral (I) control, and differential (D) control.

7. The charging control apparatus as claimed in any one of the preceding claims, wherein the control device is configured to communicate with a charger, and is configured to control a charging current by transferring the first charging current value to the charger.

8. The charging control apparatus as claimed in any one of the preceding claims, wherein the battery model comprises an electrochemical model for modelling an internal state of a secondary battery cell having one or more specifications that are substantially similar to those of the battery.

9. A battery pack, comprising:
a battery; and
the charging control apparatus as claimed in any one of the preceding claims, and optionally, wherein the control device comprises a battery management system of the battery pack.

10. A charging control method of a battery pack, the charging control method comprising:
detecting an external state value comprising at least one of a voltage, a current, and a temperature of a battery;
estimating at least one internal state value indicating an internal state of the battery by using a battery model and the external state value;
determining a first charging current value based on the at least one internal state value;
controlling a charging current of a charger based on the first charging current value; and
repeatedly performing the detecting, the estimating, the determining, and the controlling, while charging the battery pack.

11. The charging control method as claimed in claim 10, wherein the first charging current value is determined such that the at least one internal state value converges to a target value, and optionally the target value corresponds to a boundary value between a high degradation region and a low degradation region divided with reference to the internal state of the battery.

12. The charging control method as claimed in claim 10 or claim 11, wherein the internal state comprises at least one of an anode potential, a cathode potential, and a cathode concentration.

13. The charging control method as claimed in any one of claims 10 to 12 or the charging control apparatus as claimed in any one of claims 1 to 8, wherein the battery model comprises an electrochemical model for modelling an internal state of a secondary battery cell having one or more specifications that are substantially similar to those of the battery.

14. The charging control method as claimed in any one of claim 10,
wherein the estimating comprises estimating a plurality of internal state values corresponding to a plurality of internal state parameters of the battery by using the battery model and the external state value, and
wherein the determining the first charging current value comprises:
determining, for each of the plurality of internal state parameters, a current range so that the corresponding internal state value converges to the corresponding target value; and
determining a current value satisfying all of the current ranges corresponding to the plurality of internal state parameters as the first charging current value.

15. The charging control method as claimed in any one of claim 10,
wherein the estimating comprises estimating a plurality of internal state values corresponding to a plurality of internal state parameters of the battery by using the battery model and the external state value, and
wherein the determining the first charging current value comprises:
determining, for each of the plurality of internal state parameters, a second charging current value so that the corresponding internal state value converges to the corresponding target value; and
determining the first charging current value by sequentially referring to the second charging current values corresponding to the plurality of internal state parameters according to a processing sequence determined based on priorities assigned to the plurality of the internal state parameters.
